(19) Europäisches Patentamt
European Patent Office
Office européen des brevets

(11) **EP 3 449 267 B1**

(12) **EUROPEAN PATENT SPECIFICATION**

(45) Date of publication and mention
of the grant of the patent:
**07.06.2023 Bulletin 2023/23**

(21) Application number: **17720669.5**

(22) Date of filing: **26.04.2017**

(51) International Patent Classification (IPC):
**G01R 31/66** (2020.01)   **G01R 29/18** (2006.01)
**G01R 21/133** (2006.01)

(52) Cooperative Patent Classification (CPC):
**G01R 29/18;** G01R 21/133; G01R 31/66

(86) International application number:
**PCT/DK2017/050122**

(87) International publication number:
**WO 2017/186242 (02.11.2017 Gazette 2017/44)**

(54) **A METHOD FOR IDENTIFYING THE PHASES OF A MULTI-PHASE DISTRIBUTION GRID**

VERFAHREN ZUR IDENTIFIZIERUNG DER PHASEN EINES MEHRPHASIGEN
VERTEILUNGSNETZES

PROCÉDÉ POUR IDENTIFIER LES PHASES D'UN RÉSEAU DE DISTRIBUTION MULTIPHASÉ

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.04.2016 DK 201670258**

(43) Date of publication of application:
**06.03.2019 Bulletin 2019/10**

(73) Proprietor: **Kamstrup A/S
8660 Skanderborg (DK)**

(72) Inventor: **KIRKEGAARD, Dennis
8850 Bjerringbro (DK)**

(74) Representative: **Plougmann Vingtoft a/s
Strandvejen 70
2900 Hellerup (DK)**

(56) References cited:
**US-A1- 2011 130 991    US-A1- 2012 221 265
US-A1- 2014 167 735**

• **Anonymous: "Correlation coefficient calculation
- Mathematics Stack Exchange", , 14 June 2014
(2014-06-14), pages 1-1, XP055382323, Retrieved
from the Internet:
URL:https://math.stackexchange.com/questio
ns/840115/correlation-coefficient-calculat ion
[retrieved on 2017-06-16]**

**Description**

FIELD OF THE INVENTION

The present invention relates to a method for identifying which phase of a multi-phase system is associated with which terminal of a group of electricity meters associated with the multi-phase system, based on an analysis of voltage variables measured by and collected from the electricity meters.

BACKGROUND OF THE INVENTION

Multi-phase electrical power distributing grids, such a three-phase distribution systems, are used for delivering electrical power to consumers using three phases or wires coupled to points of use.

The power consumption at the point of use is metered using electricity meters connected with the different phases of the grid. In a three-phase grid each phase is connected with a separate terminal of the electricity meter and the amount of electricity delivered to the respective point of use via each of the three phases is metered by tracking voltage and current over time.

Knowing which phase of a multi-phase system the terminals of electricity meter is associated with may be used for various purposes. The load level of each phase of a multi-phase system may be determined based on information about power usage from individual meters. Knowing the load level of each phase can be used to better balance the load among phases and improve grid performance by minimizing distribution loss. Additionally, phase information could be used to make precise load profiles for each phase in a specific geographical area for keeping the maintenance cost at a minimum.

Hence, a method and system for identifying the phases of a multi-phase system would be advantageous, and in particular a more simple and reliable method and system would be advantageous. Examples of known systems and methods for identifying phases of power lines in three-phase power distribution networks can be seen in US 2011/130991 A1 and US 2014/167735 A1.

OBJECT OF THE INVENTION

An object of the present invention is to provide a method and system for identifying the phases of a multi-phase system. In particular, it may be seen as an object of the present invention to provide a method for identifying which phases of a multi-phase system is connected with which terminal of an electricity meter, not requiring the use of specialised measuring equipment.

SUMMARY OF THE INVENTION

Thus, the above described object and several other objects are intended to be obtained in a first aspect of the invention by providing a method for identifying which phase of a multi-phase system is associated with which terminal of a group of electricity meters associated with the multi-phase system, the group of electricity meters including a plurality of electricity meters of which at least one electricity meter is a reference meter for which it is known which phase of the multi-phase system is connected with which terminal, the method comprising the steps of: in each of the electricity meters, measuring and storing voltage variables induced on the terminals of the respective electricity meter during a predefined period; collecting the voltage variables from the plurality of electricity meters via a collection system; for each terminal of each electricity meter, calculating a set of mean free voltage change variables based on time derivatives of the voltage variables collected from the respective electricity meter; comparing the set of MFVC variables characterizing each terminal of each meter with the sets of MFVC variables calculated for the terminals of the reference meter and/or other meters of the group of electricity meters for which the phase is known; determining which phase of the multiple phases each terminal of each electrical meters is associated with, based on information about which sets of MFVC variables of the reference meter and/or the other meters, the set of MFVC variables characterizing each terminal of each meter are most identical to.

Hereby one or more terminals of an electricity meter connected to the multi-phase system are characterized by unique set of variables, and this unique set or variables may be compared with corresponding sets of unique variable characterizing the terminals of other meters. As the phase of some terminals are known, such as the reference meter, by comparing the sets of variables across meters, the phases of terminals can be identified by this comparison.

Hereby a method for identifying which phase the terminals of an electricity meter is connected with, is achieved. The method being based on analysis of voltage change variable measured at the terminals of each electricity meter, and thus does not require the use of external equipment for measuring grid parameters, such as voltage or current variations or for manipulating such grid parameters.

In another embodiment, the method for identifying which phase the terminal(s) of an electricity meter is/are connected with comprises the steps of: in each of the electricity meters, measuring and storing voltage variables induced on the terminals of the respective electricity meter during a predefined period; collecting the voltage variables from the plurality of electricity meters via a collection system; for each terminal of each electricity meter, calculating mean free voltage change variables (MFVC variables) based on time derivatives of the voltage variables collected from the respective electricity meter; analyzing the MFVC variables using dimension reduction techniques to determine a solution space of lower dimensionality compared to the solution space defined by the MFVC variables; for each terminal of each electricity meter, calculating a terminal point within the solution space based on the MFVC variables associated with the respective terminal; grouping the terminal points into a number of phase groups corresponding to the number of phases of the multi-phase system; determining which phase of the multi-phase system is associated with which phase group by determining which phase group the terminal point associated with the terminals of the reference meter is arranged in; determining which phase of the multiple phases each terminal of each electrical meters is associated with by determining which phase group the terminal points are arranged in.

Additionally, the above described method may further comprising the step of selecting a subset of electricity meters and based on the MFVC variables from these meters, determining a solution space, calculate terminal points, group the terminal points into phase groups, and determine which phase of the multi-phase system is associated with which phase group.

The invention further relates to a computer program product being adapted to enable a computer system comprising at least one computer having data storage means in connection therewith implement the above described method.

Hereby a method for identifying the phases of a multi-phase system based on routine voltage variables already measured by and collected from the electricity meters. The method thus does not require the use of expensive measuring equipment that is often used in known methods for identifying phases of a multi-phase system. A further advantage of the method is that a model of the topology of an electricity grind can be created and continuously updated based on voltage variables collected according to routine.

BRIEF DESCRIPTION OF THE FIGURES

The method for identifying the phases of a multi-phase system according to the invention will now be described in more detail with regard to the accompanying figures. The figures show one way of implementing the present invention and is not to be construed as being limiting to other possible embodiments falling within the scope of the attached claim set.

Figure 1 illustrates a 3-phase power grid and an advanced meter infrastructure,

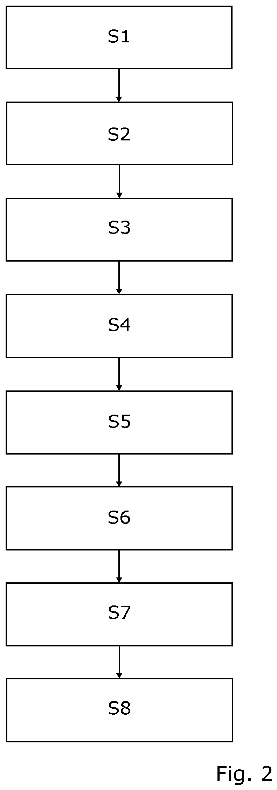

Figure 2 is a schematic system-chart representing an out-line of the method according to the invention,
Figure 3 illustrates a two-dimensional solution space with terminal points marked, and
Figure 4 illustrates the two-dimensional solution space with terminal points marked by different geometrical shapes.

DETAILED DESCRIPTION OF AN EMBODIMENT

The invention can be implemented by means of hardware, software, firmware or any combination of these. The invention or some of the features thereof can also be implemented as software running on one or more data processors and/or digital signal processors.

The individual elements of an embodiment of the invention may be physically, functionally and logically implemented in any suitable way such as in a single unit, in a plurality of units or as part of separate functional units. The invention may be implemented in a single unit, or be both physically and functionally distributed between different units and processors.

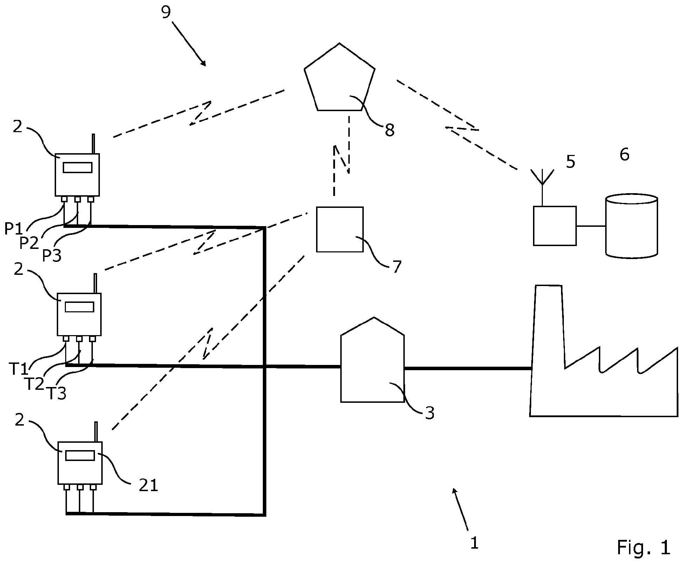

Fig 1 shows a power grid 1 having multiple phases, such as a three-phase grid, and a plurality of smart electricity meters 2 installed at respective points of use. The three phases ($P_1$, $P_2$, $P_3$) of the grid are connected with different terminals ($T_1$, $T_2$, $T_3$) of the respective electricity meters 2 and each electricity meter measures the amount of electricity delivered to the respective point of use via each of the three phases. For the purpose of metering electricity consumption, each smart meter measures and stores voltage variables, ($v_{1x}$, $v_{2x}$, $v_{3x}$) in a memory thereof (S1).

As explained above, during installation of an electricity meter the phases ($P_1$, $P_2$, $P_3$) are usually connected arbitrarily with the terminals ($T_1$, $T_2$, $T_3$). Therefore no information exists about which phases are connected with which of the terminals. The proposed invention therefore suggests a method for identifying which phase of a multi-phase system is connected with which terminal of a specific electricity meter located at a point of use.

Further, Fig. 1 illustrates an exemplary system for collecting consumption data, including the voltage variables ($v_{1x}$, $v_{2x}$, $v_{3x}$) from the smart electricity meters. The electricity meters are wirelessly connected to a communication network 9 including various receiver device in the form of repeaters 7 and collectors 8. Consumption data is transmitted from the smart meters either directly to the collector or indirectly to the collector via the repeater. The number of repeaters and collectors required for a network depends amongst others on the size and topology of the network. From the collector, consumption data from the plurality of smart meters is transmitted to a backend system 5 including a server 6 for storing, processing and analyzing consumption data. Data may also be transmitted in the opposite direction in the communication system, from the backend system to the respective smart meters. As will be further described below, data related to phase identification may be transmitted to the smart meters.

It is understood by the skilled person that other network devices such as router devices or smart meters equipped with different communication modules may also be included in the communication network. The total network is advantageously a radio network, wherein at least the network between the collector and/or repeater and the smart meters is a radio network, whereas the link between the collector and the repeater and the link to the backend system may be of any suitable type, such as wired or wireless connection. Further, it is understood by the skilled person that the shown communication network only includes a limited number of network components for illustrative purposes. Still further, the above described collection system may be determined an advanced meter infrastructure or a fixed network. However, other collection systems, such as an automatic meter reading (AMR) system, may also be used for collecting data used in the phase identification process according to the invention.

The voltage variables ($v_{1x}$, $v_{2x}$, $v_{3x}$) stored in each meter are collected via the above described collection system (S2). In one embodiment, the subsequent data processing is carried out remote from the smart meters at system level, using a computer having the necessary processing power to handle the amount of data used for the identification process. In other embodiments at least part of the data processing may take place at meter level. For example, it is also possible that part of the data processing may take place at the meter level, before meter data is transmitted to the backend system. Some kind of preprocessing of the voltage variables may take place at meter level to reduce the amount of data needed to be collected. Further, part of the data processing may also take place at an intermediate level between meter and system level, such as at a collector or other gate way used for collecting metering data from a plurality of electricity meters and forwarding the data to a server at system level.

The phase identification process is based on meter data, including voltage variables ($v_{1x}$, $v_{2x}$, $v_{3x}$) collected from a group of meters 2 connected to the same phases of the multi-phase system. The group of meters also include a reference meter 21. For the reference meter the respective phases, I II III connected to the different terminals have been identified on beforehand using known techniques and equipment. Otherwise, the reference meter is used to define the phases in the grid. To obtaining the best possible results of the identification process data from meters localized in the same topological area of the grid and expected to observe some degree of shared voltage variation are used for the analysis. Meters in the same topological area may be meters connected to the same transformer station, such as a 60kV-to-10kV transformer station. It may also be relevant to consider specifics about grid topology and physical meter position in determining which meters should be included in the phase identification process.

The voltage variables ($v_{1x}$, $v_{2x}$, $v_{3x}$) may be averaged over a certain period to minimize influences from temporal displacements among smart meters throughout the grid. Such a period may have duration of between 1 and 15 minutes, but other intervals may also be applied within the scope of the invention. Further, the voltage variables data should be temporal aligned to a certain degree and missing data points should be compensated for. In general averaging the variables over a longer period reduces the need for temporal alignment. Compared to previous method for identifying phases, such as method based on zero crossing times, the temporal alignment requirements in the present method is significantly less.

Referring to Eq. 1 and Eq. 2 below, a next processing step includes calculating time derivatives ($m_{1x}$, $m_{2x}$, $m_{3x}$) associated with the voltage variables $v_{1x}$, $v_{2x}$, $v_{3x}$ measured for each of the terminals of an electricity meter. Subsequently, the mean of all time derivatives associated with a specific point in time for a specific electricity meter is calculated as shown in Eq. 3. Finally, the mean of the time derivatives associated with a specific point in time is subtracted from each calculated time derivative of that point in time thereby providing a mean free voltage change variable (MFVC variable) ($d_{1x}$, $d_{2x}$, $d_{3x}$) (S3), as shown in Eq. 4 and Eq. 5 below:

$$(eq.\,1) \quad \begin{bmatrix} v_{11} & \cdots & v_{1n} \\ \vdots & \ddots & \vdots \\ v_{31} & \cdots & v_{3n} \end{bmatrix} \rightarrow \begin{bmatrix} (v_{12} - v_{11}) & \cdots & (v_{1n} - v_{1n-1}) \\ \vdots & \ddots & \vdots \\ (v_{32} - v_{31}) & \cdots & (v_{3n} - v_{3n-1}) \end{bmatrix} = \begin{bmatrix} m_{11} & \cdots & m_{1n-1} \\ \vdots & \ddots & \vdots \\ m_{31} & \cdots & m_{3n-1} \end{bmatrix} = \bar{\bar{m}}^T$$

$$(eq.\,2) \quad \bar{\bar{m}} = \begin{bmatrix} \begin{bmatrix} m_{11} \\ \vdots \\ m_{1n-1} \end{bmatrix} \begin{bmatrix} m_{21} \\ \vdots \\ m_{2n-1} \end{bmatrix} \begin{bmatrix} m_{31} \\ \vdots \\ m_{3n-1} \end{bmatrix} \end{bmatrix}$$

$$(eq.3) \quad \overline{\overline{m}} \cdot \begin{bmatrix} 1/3 \\ 1/3 \\ 1/3 \end{bmatrix} = \overline{m}_\mu$$

$$(eq.4) \quad \overline{\overline{m}} - [\overline{m}_\mu \quad \overline{m}_\mu \quad \overline{m}_\mu] = \overline{\overline{d}}$$

$$(eq.5) \quad \overline{\overline{d}} = [\overline{d}_1 \quad \overline{d}_2 \quad \overline{d}_3] = \begin{bmatrix} \begin{bmatrix} d_{11} \\ \vdots \\ d_{1n-1} \end{bmatrix} \begin{bmatrix} d_{21} \\ \vdots \\ d_{2n-1} \end{bmatrix} \begin{bmatrix} d_{31} \\ \vdots \\ d_{3n-1} \end{bmatrix} \end{bmatrix}$$

The purpose of removing the mean from the voltage change variables is to relatively increase or amplify the unbalanced variations contained in the voltage change for the individual phases and suppress the balanced influence of unwanted effects on the calculated voltage change variables, such as originates from balanced load change, generators and winding changes present in the distribution grid.

An alternative to the calculation of the mean for a specific electricity meter could be to calculate the mean for all the meters or a selected group of meters and thus subtracting the same mean from the time derivatives calculated for each of all the meters or the group of meters. As envisaged by the skilled person, other alternatives to calculating and subtracting the mean may also be applied to arrive at the MFVC variables. As described above the objective is too relatively increase any unbalanced variations, which is may be achieved by removing any common components related to balanced load changes affecting all meters. Removing a common component may also be achieved in other ways as an alternative to subtraction of the mean.

The result of this processing step is a set of MFVC variables associated with each terminal of each electricity meter. The set MFVC variables characterize the voltage variations measured at each of the terminals of a given electricity meter. Referring to Eq. 5, the MFVC variables are presented in a matrix containing three MFVC variable vectors.

Further, in Eq. 6 below, the MFVC variable vectors are normalized by dividing each vector by the square root of its dot product. The normalized MFVC variable vectors are arranged in a matrix $\overline{\overline{l}}$ for each meter and $\overline{\overline{L}}$ for all the meters initially included in the phase identification process.

$$(eq.6) \quad \overline{l}_x = \overline{d}_x \left( [\overline{d}_x]^T [\overline{d}_x] \right)^{-1/2}$$

$$\overline{\overline{l}}_m = [\overline{l}_1 \quad \overline{l}_2 \quad \overline{l}_3]_m$$

$$\overline{\overline{L}} = [\overline{\overline{l}}_1 \quad \overline{\overline{l}}_2 \quad \cdots \quad \overline{\overline{l}}_M]$$

Following definition of the set of MFVC variables/MFVC variable vectors, the MFVC variables characterizing each terminal of each meter are compared or analyzed in relation to MFVC variables for the terminals of the reference meter and/or other meters for which the phase is known. Based on this comparison it may be determining which phase of the multiple phases each terminal of each electrical meters is associated with.

The MFVC variable may be compared using a number of different statistical methods and measures, such as cross-correlation or Principle component analysis (PCA) as will be further described below.

In one embodiment the MFVC variables are first used to define a solution space of reduced dimensionality (S4) to be able to analyze the data collected. Of the meters initially included in the phase identification process, the data from only a subset of meters may be used to define the solution space. The purpose of selecting only a subset is to identify meters that best represent the general voltage fluctuations occurring in the grid, and to reduce the impact of meters subject to specific voltage fluctuations, due to for example local loads, grid topology characteristics, etc.

The subset of electricity meters may be chosen based on their voltage variance calculated based on the MFVC variables. The meters having the smallest variances are selected for the subset, for example meters having a variance in the interval from the minimum variance registered to twice the minimum variance, may be chosen. The variance as selection parameter is based on the insight of the inventors that meters having the smallest variance will most likely be subject to the smallest individual impedance or be least loaded. Therefore, these meters will most likely be subject to fluctuations experienced by a large number of meters. Such fluctuations or shared features may originate from shared impedance in substations or the distribution network, or from single-phase voltage variations caused by power plants or the transmission network. As envisaged by the skilled person, a subset of meter may also be chosen based on a number of other criteria, either simpler or more complex in nature. A subset of meters may contain between 2 and 50 percent of the meters initially selected for the phase identification process but is not limited to this interval.

The MFVC variables from the selected subset of meters is used to define the solution space of reduced dimensionality (S4) to be able to analyze the collected data. The definition of the solution space of reduced dimensionality may be performed using a number of computational methods known to the skilled person. The overall objective of the process is to create a numerical model for identifying each of a plurality of phases connected to an electricity meter, based on the voltage variables ($v_{1x}$, $v_{2x}$, $v_{3x}$) measurements by each specific meter.

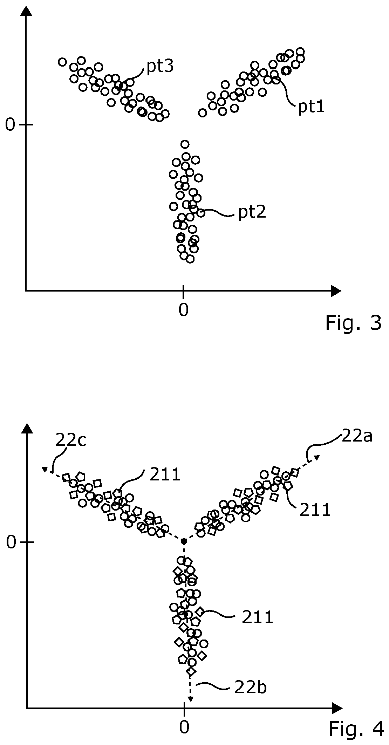

In one embodiment the solution space of reduced dimensionality is found using principle component analysis (PCA) performed on the normalized MFVC variables from the subset of meters. PCA is widely used and well described in the arts and will thus not be further described. In one embodiment, a two-dimensional solution space as shown in Fig. 3, is identified using principal component analysis. A two-dimensional solution space seems a reasonable choice since the MFVC variable vectors from one meter, see Eq. 5, span a two-dimensional space, i.e. the rank of the matrix d constituted by the MFVC variable vectors from a single meter is two. The skilled person would know that solution spaces having fewer or more dimensions could also be defined.

Following the definition of the solution space, the voltage variations measured at each terminal of the plurality of meters, i.e. the MFVC variable vectors are mapped onto the two-dimensional solution space. This mapping is done by calculating a coordinate set related to the solution space for each of the MFVC variable vectors (S5). More specifically the coordinate set is found by projecting the MFVC variables vector for each terminal onto the solution space. In one embodiment, the coordinate set for each MFVC variable vectors is calculated by finding the dot product of the respective MFVC variables vector and the principle vectors defining the axis of the solution space as shown in Fig. 3.

In the following the coordinate set will also be denoted a terminal point ($pt_1$, $pt_2$, $pt_3$) as the set of coordinates are a representation of measurements made at a specific terminal of a specific electricity meter. In Fig. 3 the terminal points ($pt_1$, $pt_2$, $pt_3$) for each meter included in the selected subset is shows in the two-dimensional solution space. As seen from the figure the terminal points are group in three distinctive groups (S6), corresponding to the three phases of the grid.

As described above, each terminal point $pt_1$, $pt_2$, $pt_3$ corresponds to a MFVC variables vector, which is defined by the voltage variables measured at a specific terminal of a specific meter. Thus, by identifying which terminal point is arranged in which group, it is possible to determine the phase associated with the terminal corresponding to the respective terminal point. In Fig. 4 the terminal points are marked by different geometrical shapes indicating which terminal the terminal point is related to. Further, additional information, such as numbers, may be associated with each of the geometrical shapes/terminal points to indicate which electricity meter the terminal point is associated with.

Terminal points 211 associated with the terminals of the reference meter described above, are also plotted in the solution space as shown in Fig. 4. Based on the position of the terminal points 211 and the knowledge about how the phases are connected to the reference meter, a phase number (I, II or III) may be assigned to each of the groups (S7). In an exemplary embodiment phase I is assigned to the group of terminal points pointing in the two-o'clock direction in Fig. 4, phase II is assigned to the group of terminal points pointing in the six-o'clock direction, and phase III is assigned to the group of terminal points pointing in the ten-o'clock direction. By finding out which group a specific terminal point is arranged in, it may be determined which phase the terminal is associated with.

Having defined a number of phase groups associated with each phase based on the selected subset of smart meters, the phases connected to the terminals of all the meters initially included in the phase identification process can be identified. In other words, the selected subset of meters have been used to create a phase groups model, which the terminals of the remaining meters can be compared to.

If the phase of a terminal cannot be determined or if determined with an unacceptable level of uncertainty using the above described methodology, secondary methods may be used for determining the phase of a terminal or for confirming the phase initially determined. Such secondary methods may for example include cross-correlation as will be further described below. Cross-correlation may also be used alone, without creating a numerical model and defining a solution space of reduced dimensional.

Data characterizing the terminals already assigned to a phase, such as the MFVC variables from the reference meter, is used as input for the correlation and by comparing MFVC variable vectors characterizing the unassigned terminals to this data, phases may be assigned to the terminals of additional meters. More specifically, each of the unassigned MFVC variable vectors are compared to each of the MFVC variable vectors characterizing an assigned terminal. In one embodiment this is done by constructing a matrix $\bar{\bar{Z}}$ containing all the assigned or clustered terminal of the initial population of meters, $\bar{\bar{L}}$, arranged for each meter according cluster a, b and c:

$$\bar{\bar{Z}} = [\bar{l}_a \quad \bar{l}_b \quad \bar{l}_c]_m$$

For each meter matrix, $\bar{\bar{l}}$ belonging to still unclassified meters, the probability, p that a specific terminal is assigned to a given phase is calculated according to Eq. 7 using all the assigned terminal arranged in $\bar{\bar{Z}}$ .

$$(eq.\,7) \quad \bar{\bar{p}} = \bar{\bar{Z}}^T \bar{\bar{l}}$$

For all the entries, i.e. probabilities arranged in the matrix $\bar{\bar{p}}$ , it is checked whether a predetermined threshold, $\eta$ is reached. If the threshold is reached (p > $\eta$) the entries are set to 1 (one), otherwise 0 (zero).

In one embodiment the threshold, $\eta$ is defined as:

$$\eta = \frac{4.89}{\sqrt{N}}$$

Where N is the number of samples, i.e. voltage variables measured for each of the terminals of the electricity meters.

When an unassigned terminals has been correlated with all the previous assigned terminals, the result of calculating probabilities and assigning entries above a certain threshold to 1 (one) is an overview of which phase a terminal is most likely to be connected with. For a give terminal the result may look like the below example:

|         | Terminal 1 | Terminal 2 | Terminal 3 |
|---------|------------|------------|------------|
| Phase 1 | 24         | 0          | 0          |
| Phase 2 | 0          | 0          | 13         |
| Phase 3 | 1          | 23         | 0          |

From the exemplary table can be seen that the correlation of the MFVC variable vector characterizing terminal 1 with MFVC variable vectors characterizing terminals already assigned to phase 1, 24 times has resulted in a probability above the threshold. Similar, no instances has been found of correlation of the MFVC variable vector characterizing terminal 1 with MFVC variable vectors known to be characterizing terminal 2, being above the threshold. An in one instance the correlation of the MFVC variable vector characterizing terminal 1 with MFVC variable vectors known to be characterizing terminal 3, has been above the threshold. Similar data about terminals 2 and 3 can be found in the table.

Based on the data shown in the above table it can concluded that terminal 1 is most likely connected to phase 1, terminal 2 is most likely connected to phase3 and terminal 3 is most likely connected to phase 2. By calculating the probabilities for the MFVC variable vector of each terminal of each unassigned meter, phases may be assigned to additional meters or previous assignments using the numerical model approach described earlier may be verified.

As described above a characterization of the terminals of each meter was created based on voltage variations measured at the respective terminals. The characterization was made in the form of a matrix containing three MFVC variable vectors, one for each terminal. These MFVC variable vectors are used to calculate terminal points $pt_1$, $pt_2$, $pt_3$ for each terminal of each meter, as described above. The terminal points are then inserted or plotted into the solution space and by finding out which group a specific terminal point is arranged in, it may be determine which phase a corresponding terminal is associated with.

The process of linking terminal points, i.e. terminals, to phase groups may be performed in an automated and autonomous manner by creating a learning algorithm. Various methods for grouping unlabeled data, such as k-means or Expectation Maximization with a Gaussian Mixture Model (EM_GMM), which are known to the skilled person, may be used for creating such algorithm.

In an alternative embodiment, each of the three phases may be represented by a direction 22a, 22b, 22c in the solution space, and each of the terminal points may be linked to one of these three directions using manual or autonomous methods. In one embodiment the three directions may be defined by considering coordinates from one meter having the most significant discrimination between its terminal points in the solution space, and based on these terminal points define the above mentioned directions.

The information about which phase is connected to which terminal of an electricity meter may be used for various purposes. The load level of each phase of a multi-phase system may be determined based on information about power usage from individual meters. Knowing the load level of each phase can be used to better balance the phases and improve grid performance.

Further, the phase information may be distributed to each electricity meter and displayed on a display of the meter. The phase information may also be stored in a database and distributed upon request, for example to installation or maintenance personnel during installation, repair or modification of existing or new electrical installations. Such distribution of phase information may be effectuated by a handheld device, such as a dedicated installation tool or general purpose device, such as a Smartphone or computer. During installation of new heavy loads, such as a charger for an electrical car, installation personal may request the phase information from a central server using the handheld device. Based on the phase information received the new load may be connected to the phase best suited, for example the presently least loaded phase. The skilled person may also envisage other uses, such as active load control etc.

When it is stated that voltage variables or other variables or values are collected, processed or treated in any other way, it is implicit that it is information or data representing such values or variables that are collected, processed or treated. Further, data and information are terms used interchangeably throughout the specification.

The invention is defined by the appended claims.

**Claims**

1. A method for identifying which phase ($P_1$, $P_2$, $P_3$) of a multi-phase system (1) is associated with which terminal ($T_1$, $T_2$, $T_3$) of a group of electricity meters (2) associated with the multi-phase system, the group of electricity meters including a plurality of electricity meters of which at least one electricity meter is a reference meter (21) for which it is known which phase of the multi-phase system is connected with which terminal, the method comprising the steps of:

    - in each of the electricity meters (2), measuring and storing voltage variables ($v_{1n}$, $v_{2n}$, $v_{3n}$) induced on the terminals ($T_1$, $T_2$, $T_3$) of the respective electricity meter (S1) during a predefined period;
    - collecting the voltage variables from the plurality of electricity meters via a collection system (S2);
    - for each terminal of each electricity meter, calculating a set of mean free voltage change, MFVC, variables based on time derivatives of the voltage variables collected from the respective electricity meter (S3);
    - comparing the set of MFVC variables characterizing each terminal of each meter with the sets of MFVC variables calculated for the terminals of the reference meter and/or other meters of the group of electricity meters for which the phases are known;
    - determining which phase of the multiple phases each terminal of each electrical meter is associated with, based on information about which sets of MFVC variables of the reference meter and/or the other meters, the set of MFVC variables characterizing each terminal of each meter are most identical to.

2. A method according to claim 1, wherein the set of MFVC variables characterizing each terminal of each meter are compared with the sets of MFVC variables calculated for the terminals of the reference meter and/or other meters of the group of electricity meters for which the phase is known by using dimension reduction techniques to determine a solution space of lower dimensionality compared to the solution space defined by the MFVC variables (S4), and wherein the method further comprises the steps of:

    - for each terminal of each electricity meter, calculating a terminal point ($pt_1$, $pt_2$, $pt_3$) within the solution space based on the mean free voltage change variables associated with the respective terminal (S5);
    - grouping the terminal points into a number of phase groups corresponding to the number of phases of the multi-phase system (S6);
    - determining which phase of the multi-phase system is associated with which phase group by determining which phase group the terminal point (211) associated with the terminals of the reference meter (21) is arranged in (S7);
    - determining which phase of the multiple phases each terminal of each electrical meter is associated with by determining which phase group the terminal points are arranged in (S8).

3. A method according to claim 1 or 2, further comprising the step of selecting a subset of electricity meters and based on the MFVC variables from these meters, determining a solution space (S4), calculate terminal points ($pt_1$, $pt_2$, $pt_3$) (S5), group the terminal points into phase groups (S6), and determine which phase of the multi-phase system is associated with which phase group (S7).

4.  A computer program product being adapted to enable a computer system comprising at least one computer having data storage means in connection therewith to identify the phase connected to a terminal of an electricity meter by:

    - calculating mean free voltage change, MFVC, variables for each terminal of each a plurality of electricity meters based on information about voltage variables ($v_{1n}$, $v_{2n}$, $v_{3n}$) induced on the terminals ($T_1$, $T_2$, $T_3$) of the respective electricity meter during a predefined period ;
    - analyzing the MFVC variables using dimension reduction techniques to determine a solution space of lower dimensionality compared to the solution space originally defined by the MFVC variables;
    - calculating a terminal point ($pt_1$, $pt_2$, $pt_3$) within the solution space representing the MFVC variables associated with the respective terminal, for each terminal of each electricity meter;
    - grouping the calculated terminal points representing specific terminals of a specific electricity meter within the solution space into a predetermined number of phase groups (S6);
    - determining which phase each terminal of each of the electrical meters is associated with by determining which phase group the terminal point representing the respective terminal is associated with (S8).

## Patentansprüche

1.  Verfahren zum Identifizieren, welche Phase ($P_1$, $P_2$, $P_3$) eines mehrphasigen Systems (1) welchem Anschluss ($T_1$, $T_2$, $T_3$) einer dem mehrphasigen System zugeordneten Gruppe von Elektrizitätszählern (2) zugeordnet ist, wobei die Gruppe von Elektrizitätszählern eine Vielzahl von Elektrizitätszählern beinhaltet, von denen mindestens ein Elektrizitätszähler ein Referenzzähler (21) ist, für den bekannt ist, welche Phase des mehrphasigen Systems mit welchem Anschluss verbunden ist, wobei das Verfahren die folgenden Schritte umfasst:

    - in jedem der Elektrizitätszähler (2) Messen und Speichern von Spannungsvariablen ($v_{1n}$, $v_{2n}$, $v_{3n}$), die an den Anschlüssen ($T_1$, $T_2$, $T_3$) des jeweiligen Elektrizitätszählers während einer vorgegebenen Zeitspanne induziert werden (S1);
    - Erfassen der Spannungsvariablen von der Vielzahl von Elektrizitätszählern über ein Erfassungssystem (S2);
    - für jeden Anschluss jedes Elektrizitätszählers Berechnen eines Satzes von Variablen der mittleren freien Spannungsänderung, MFVC, auf Grundlage von zeitlichen Ableitungen der von dem jeweiligen Elektrizitätszähler erfassten Spannungsvariablen (S3);
    - Vergleichen des Satzes von MFVC-Variablen, der jeden Anschluss jedes Zählers charakterisiert, mit den Sätzen von MFVC-Variablen, die für die Anschlüsse des Referenzzählers und/oder anderer Zähler der Gruppe von Elektrizitätszählern, für die die Phasen bekannt sind, berechnet wurden;
    - Bestimmen, welcher Phase der mehreren Phasen jeder Anschluss jedes Elektrizitätszählers zugeordnet ist, auf Grundlage der Informationen, welchen Sätzen von MFVC-Variablen des Referenzzählers und/oder der anderen Zähler der Satz von MFVC-Variablen, der jeden Anschluss jedes Zählers charakterisiert, am identischsten ist.

2.  Verfahren nach Anspruch 1, wobei der Satz von MFVC-Variablen, der jeden Anschluss jedes Zählers charakterisiert, mit den Sätzen von MFVC-Variablen verglichen wird, die für die Anschlüsse des Referenzzählers und/oder anderer Zähler der Gruppe von Elektrizitätszählern, für die die Phase bekannt ist, berechnet wurden, indem Dimensionsreduktionstechniken verwendet werden, um einen Lösungsraum mit geringerer Dimensionalität im Vergleich zu dem Lösungsraum, der durch die MFVC-Variablen (54) definiert ist, zu bestimmen, und wobei das Verfahren ferner die folgenden Schritte umfasst:

    - für jeden Anschluss jedes Elektrizitätszählers Berechnen eines Anschlusspunkts ($pt_1$, $pt_2$, $pt_3$) innerhalb des Lösungsraums auf Grundlage der dem jeweiligen Anschluss zugeordneten Variablen der mittleren freien Spannungsänderung (S5);
    - Gruppieren der Anschlusspunkte in eine Anzahl von Phasengruppen entsprechend der Anzahl von Phasen des mehrphasigen Systems (S6);
    - Bestimmen, welche Phase des mehrphasigen Systems welcher Phasengruppe zugeordnet ist, indem bestimmt wird, in welcher Phasengruppe der den Anschlüssen des Referenzzählers (21) zugeordnete Anschlusspunkt (211) angeordnet ist (S7);
    - Bestimmen, welcher Phase der mehreren Phasen jeder Anschluss jedes Elektrizitätszählers zugeordnet ist, indem bestimmt wird, in welcher Phasengruppe die Anschlusspunkte angeordnet sind (S8).

**3.** Verfahren nach Anspruch 1 oder 2, ferner umfassend den Schritt eines Auswählens einer Teilmenge von Elektrizitätszählern und, auf Grundlage der MFVC-Variablen von diesen Zählern, des Bestimmens eines Lösungsraums (S4), des Berechnens von Anschlusspunkten ($pt_1$, $pt_2$, $pt_3$) (S5), des Gruppierens der Anschlusspunkte in Phasengruppen (S6) und des Bestimmens, welche Phase des mehrphasigen Systems welcher Phasengruppe zugeordnet ist (S7).

**4.** Computerprogrammprodukt, das dazu angepasst ist, es einem Computersystem, das mindestens einen Computer mit Datenspeichermitteln in Verbindung damit umfasst, zu ermöglichen, die Phase, die mit einem Anschluss eines Elektrizitätszählers verbunden ist, durch Folgendes zu identifizieren:

- Berechnen der Variablen der mittleren freien Spannungsänderung,MFVC,-für jeden Anschluss jedes einer Vielzahl von Elektrizitätszählern auf Grundlage von Informationen über Spannungsvariablen ($v_{1n}$, $v_{2n}$, $v_{3n}$), die an den Anschlüssen ($T_1$, $T_2$, $T_3$) des jeweiligen Elektrizitätszählers während einer vorgegebenen Zeitspanne induziert werden;
- Analysieren der MFVC-Variablen unter Verwendung von Dimensionsreduktionstechniken, um einen Lösungsraum mit geringerer Dimensionalität im Vergleich zu dem ursprünglich durch die MFVC-Variablen definierten Lösungsraum zu bestimmen;
- Berechnen eines Anschlusspunkts ($pt_1$, $pt_2$, $pt_3$) innerhalb des Lösungsraums, der die dem jeweiligen Anschluss zugeordneten MFVC-Variablen darstellt, für jeden Anschluss jedes Elektrizitätszählers;
- Gruppieren der berechneten Anschlusspunkte, die bestimmte Anschlüsse eines bestimmten Elektrizitätszählers innerhalb des Lösungsraums darstellen, in eine vorbestimmte Anzahl von Phasengruppen (S6);
- Bestimmen, welcher Phase jeder Anschluss jedes Elektrizitätszählers zugeordnet ist, indem bestimmt wird, welcher Phasengruppe der Anschlusspunkt, der den jeweiligen Anschluss darstellt, zugeordnet ist (S8).

**Revendications**

**1.** Procédé permettant l'identification de quelle phase ($P_1$, $P_2$, $P_3$) d'un système multiphasé (1) est associée à quelle borne ($T_1$, $T_2$, $T_3$) d'un groupe de compteurs électriques (2) associé au système multiphasé, le groupe de compteurs électriques comprenant une pluralité de compteurs électriques dont au moins un compteur électrique est un compteur de référence (21) pour lequel est connu quelle phase du système multiphasé est connectée à quelle borne, le procédé comprenant les étapes de :

- dans chacun des compteurs électriques (2), mesure et stockage des variables de tension ($v_{1n}$, $v_{2n}$, $v_{3n}$) induites aux bornes ($T_1$, $T_2$, $T_3$) du compteur électrique respectif (S1) durant une période prédéfinie ;
- collecte des variables de tension en provenance de la pluralité de compteurs électriques par l'intermédiaire d'un système de collecte (S2) ;
- pour chaque borne de chaque compteur électrique, calcul d'un ensemble de variables de variation de tension libre moyenne, MFVC, sur la base des dérivées temporelles des variables de tension collectées en provenance du compteur électrique respectif (S3) ;
- comparaison de l'ensemble de variables MFVC caractérisant chaque borne de chaque compteur avec les ensembles de variables MFVC calculées pour les bornes du compteur de référence et/ou d'autres compteurs du groupe de compteurs électriques dont les phases sont connues ;
- détermination pour savoir à quelle phase des phases multiples chaque borne de chaque compteur électrique est associée, sur la base d'informations concernant les ensembles de variables MFVC du compteur de référence et/ou des autres compteurs, auquel l'ensemble de variables MFVC caractérisant chaque borne de chaque compteur sont les plus identiques.

**2.** Procédé selon la revendication 1, ledit ensemble de variables MFVC caractérisant chaque borne de chaque compteur étant comparé aux ensembles de variables MFVC calculées pour les bornes du compteur de référence et/ou d'autres compteurs du groupe de compteurs électriques dont la phase est connu à l'aide des techniques de réduction de dimension pour déterminer un espace de solutions de dimensionnalité inférieure comparé à l'espace de solutions défini par les variables MFVC (S4), et ledit procédé comprenant en outre les étapes de :

- pour chaque borne de chaque compteur électrique, calcul d'un point de borne ($pt_1$, $pt_2$, $pt_3$) dans l'espace de solutions sur la base des variables de variation de tension libre moyennes associées à la borne respective (S5) ;
- groupement des points de borne en un nombre de groupes de phases correspondant au nombre de phases du système multiphasé (S6) ;

- détermination pour savoir quelle phase du système multiphasé est associée à quel groupe de phases en déterminant dans quel groupe de phases le point de borne (211) associé aux bornes du compteur de référence (21) est agencé (S7) ;
- détermination pour savoir à quelle phase des multiples phases chaque borne de chaque compteur électrique est associée en déterminant dans quel groupe de phases les bornes sont agencées (S8).

3. Procédé selon la revendication 1 ou 2, comprenant en outre l'étape de sélection d'un sousensemble de compteurs électriques et sur la base des variables MFVC en provenance de ces compteurs, détermination d'un espace de solutions (S4), calcul de points de borne ($pt_1$, $pt_2$, $pt_3$) (S5), groupement des points de borne en groupes de phases (S6) et détermination pour savoir quelle phase du système multiphasé est associée à quel groupe de phases (S7).

4. Produit-programme informatique adapté pour permettre à un système informatique comprenant au moins un ordinateur possédant des moyens de stockage de données en connexion avec lui d'identifier la phase connectée à une borne d'un compteur électrique par :

   - calcul de variables de variation de tension libre moyenne, MFVC, pour chaque borne de chacun d'une pluralité de compteurs électriques sur la base d'informations concernant les variables de tension ($v_{1n}$, $v_{2n}$, $v_{3n}$) induites sur les bornes ($T_1$, $T_2$, $T_3$) du compteur électrique respectif durant une période prédéfinie ;
   - analyse des variables MFVC à l'aide de techniques de réduction de dimension pour déterminer un espace de solutions de dimensionnalité inférieure comparé à l'espace de solutions défini à l'origine par les variables MFVC ;
   - calcul d'un point de borne ($pt_1$, $pt_2$, $pt_3$) dans l'espace de solutions représentant les variables MFVC associées à la borne respective, pour chaque borne de chaque compteur électrique ;
   - groupement des points de borne calculés représentant des bornes spécifiques d'un compteur électrique spécifique dans l'espace de solutions en un nombre prédéfini de groupes de phases (S6) ;
   - détermination pour savoir à quelle phase chaque borne de chacun des compteurs électriques est associée en déterminant à quel groupe de phases le point de borne représentant la borne respective est associé (S8).

Fig. 1

Fig. 2

Fig. 3

Fig. 4

**EP 3 449 267 B1**

**REFERENCES CITED IN THE DESCRIPTION**

**Patent documents cited in the description**

- US 2011130991 A1

- US 2014167735 A1